(19) Europäisches Patentamt / European Patent Office / Office européen des brevets

(11) **EP 4 047 760 B1**

(12) **EUROPEAN PATENT SPECIFICATION**

(45) Date of publication and mention
of the grant of the patent:
**26.06.2024 Bulletin 2024/26**

(21) Application number: **20932251.0**

(22) Date of filing: **20.04.2020**

(51) International Patent Classification (IPC):
*H01S 5/02345* *(2021.01)*     *H01S 5/042* *(2006.01)*
*H01S 5/0239* *(2021.01)*     *H01S 5/062* *(2006.01)*
*H01L 23/00* *(2006.01)*

(52) Cooperative Patent Classification (CPC):
(C-Sets available)
**H01S 5/02345; H01S 5/0428;** H01L 24/48;
H01L 24/49; H01L 2224/48091; H01L 2224/48227;
H01L 2224/49111; H01L 2224/49175;
H01L 2224/85455; H01L 2924/00014;
H01L 2924/12042; H01S 5/0239; H01S 5/06226

(Cont.)

(86) International application number:
**PCT/CN2020/085725**

(87) International publication number:
**WO 2021/212289 (28.10.2021 Gazette 2021/43)**

(54) **LASER EMITTING APPARATUS**

LASEREMITTER

APPAREIL D'ÉMISSION LASER

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**24.08.2022 Bulletin 2022/34**

(73) Proprietor: **Shenzhen Goodix Technology Co., Ltd.
Shenzhen, Guangdong 518045 (CN)**

(72) Inventors:
• **LIN, Yubo
Shenzhen, Guangdong 518045 (CN)**
• **DU, Canhong
Shenzhen, Guangdong 518045 (CN)**

(74) Representative: **Kraus & Lederer PartGmbB
Thomas-Wimmer-Ring 15
80539 München (DE)**

(56) References cited:
CN-A- 1 662 130         CN-A- 1 720 617
CN-A- 101 378 177       CN-A- 105 122 443
CN-A- 106 486 887       DE-U1-202006 005 148
US-A1- 2004 233 946     US-A1- 2009 059 981
US-A1- 2017 086 300     US-A1- 2019 312 407

(52) Cooperative Patent Classification (CPC): (Cont.)

C-Sets
H01L 2224/48091, H01L 2924/00014;
H01L 2224/85455, H01L 2924/01046;
H01L 2224/85455, H01L 2924/01079;
H01L 2924/00014, H01L 2224/45099

## Description

## TECHNICAL FIELD

The embodiments of the present application relate to the technical field of photoelectric, and in particular, to a laser emitting apparatus.

## BACKGROUND

A laser emitting apparatus can emit a laser signal under the control of a driving signal. For example, in an application scenario, an instantaneous current is generated by a drive signal control circuit such that a laser emitting apparatus emits laser. However, since a circuit element itself in a circuit structure of the laser emitting apparatus has parasitic inductance, when the driving signal controls the laser emitting apparatus, the change of the instantaneous current is relatively slow due to the influence of the parasitic inductance, thereby affecting the effect of laser emission of the laser emitting apparatus. A laser diode integrated with a capacitor and a driver on a circuit board is for example known from US 2019/0312407 A and US 2004/0233946 A1.

## SUMMARY

In view of this, one of the technical problems to be solved by the embodiments of the present disclosure is to provide a laser emitting apparatus for overcoming the defects in the prior art that the change of an instantaneous current is relatively slow due to parasitic inductance in a circuit to affect the effect of laser emission of the laser emitting apparatus. The object of the present invention is solved by an apparatus as defined in independent claim 1. Preferred embodiments are defined in the dependent claims.

The embodiments of the present disclosure provide a laser emitting apparatus, including: a drive assembly, a laser emitter, an energy storage module, and a circuit board.

The laser emitter is a bare-die laser emitter. An input end of the laser emitter is electrically connected to the energy storage module, and an output end of the laser emitter is electrically connected to the drive assembly. The energy storage module and an external power supply are used to generate an electrical signal required for driving the laser emitter. The drive assembly is used to output a driving signal to control the energy storage module and the external power supply to output the electrical signal to the laser emitter, so as to enable the laser emitter to emit laser. The drive assembly, the laser emitter, and the energy storage module are fixed on the circuit board, and a ground layer is arranged in the circuit board.

The laser emitter is fixed to an upper surface of the circuit board through at least one anode connecting line, and a cathode of the laser emitter is arranged on a lower surface of the laser emitter.

Optionally, in one embodiment of the present application, a nickel-palladium-gold layer is arranged between the laser emitter and the circuit board, and at least one anode connecting line is bound to the nickel-palladium-gold layer.

The cathode of the laser emitter is fixed to the upper surface of the circuit board through silver paste.

The distance between the lower surface of the laser emitter and the upper surface of the circuit board is less than or equal to 30 $\mu$m.

Optionally, in one embodiment of the present application, a first end of the energy storage module is electrically connected to an input end of the laser emitter, and a second end of the energy storage module is grounded.

An output end of the laser emitter is electrically connected to a first input end of the drive assembly.

A second input end of the drive assembly receives a pulse signal, and an output end of the drive assembly is grounded.

Optionally, in one embodiment of the present application, the drive assembly includes a waveform shaping circuit and a switching unit.

An input end of the waveform shaping circuit is a second input end of the drive assembly, and an output end of the waveform shaping circuit is connected to a control end of the switching unit. An input end of the switching unit is the first input end of the drive assembly, and an output end of the switching unit is the output end of the drive assembly.

Optionally, in one embodiment of the present application, the switching unit is a field effect transistor. A drain electrode of the field effect transistor is the input end of the switching unit, a gate electrode of the field effect transistor is a control end of the switching unit, and a source electrode of the field effect transistor is the output end of the switching unit.

Optionally, in one embodiment of the present application, the distance between the lower surface of the laser emitter and the ground layer of the circuit board is less than or equal to 0.1 mm.

Optionally, in one embodiment of the present application, the circuit board includes a wiring layer, an intermediate dielectric layer, and a ground layer. The intermediate dielectric layer is located between the wiring layer and the ground layer. The thickness of the intermediate dielectric layer is between 12.5 $\mu$m and 50 $\mu$m.

Optionally, in one embodiment of the present application, a first ground hole and a second ground hole are formed in the circuit board.

The first ground hole is formed below the drive assembly, and the drive assembly is grounded through the first ground hole.

The second ground hole is formed below the energy storage module, and the energy storage module is grounded through the second ground hole.

Optionally, in one embodiment of the present application, the laser emitting apparatus further includes a reinforcing plate, and the reinforcing plate is fixed to the lower surface of the circuit board.

According to the laser emitting apparatus provided by the embodiments of the present application, since the laser emitter is a bare-die laser emitter, the distance between the laser emitter and the ground layer of the circuit board is reduced, and local mutual inductance is increased; the distance between the laser emitter and other circuit elements in the laser emitting apparatus is also reduced, local self-inductance is reduced, and parasitic inductance generated by the circuit in the laser emitting apparatus is reduced on the whole, so that the change of an instantaneous current generated when the driving signal controls the laser emitting apparatus is accelerated, the anti-interference capability of laser emission is improved, and the effect of laser emission is improved.

## BRIEF DESCRIPTION OF THE DRAWINGS

Some specific embodiments of the embodiments of the present application will be described in detail hereinafter, in an exemplary rather than restrictive manner, with reference to the accompanying drawings. The same reference signs in the accompanying drawings represent the same or similar components or parts. Those skilled in the art should understand that these drawings are not necessarily drawn by ratio. In the drawings:

FIG. 1 illustrates a circuit schematic diagram of a laser emitting circuit in a laser emitting apparatus useful for the understanding of the present application;

FIG. 2 illustrates a sectional view of the laser emitting apparatus useful for the understanding of the present application;

FIG. 3 illustrates a sectional view of a first laser emitting apparatus provided by Embodiment of the present application;

FIG. 4 illustrates a schematic structural diagram of a circuit of the laser emitting apparatus provided by various embodiments of the present application;

FIG. 5 illustrates a schematic structural diagram of the circuit of the laser emitting apparatus provided by various embodiments of the present application;

FIG. 6a illustrates a schematic shape diagram of a connecting line provided by various embodiments of the present application;

FIG. 6b illustrates a sectional view of a circuit board provided by various embodiments of the present application;

FIG. 6c illustrates a vertical view of the circuit board provided by various embodiment of the present application;

FIG. 7 illustrates a sectional view of a second laser emitting apparatus provided by Embodiment of the present application; and

FIG. 8 illustrates a sectional view of a third laser emitting apparatus provided by Embodiment of the present application.

## DETAILED DESCRIPTION

Specific implementation of the embodiments of the present disclosure is further described below with reference to the accompanying drawings of the embodiments of the present disclosure.

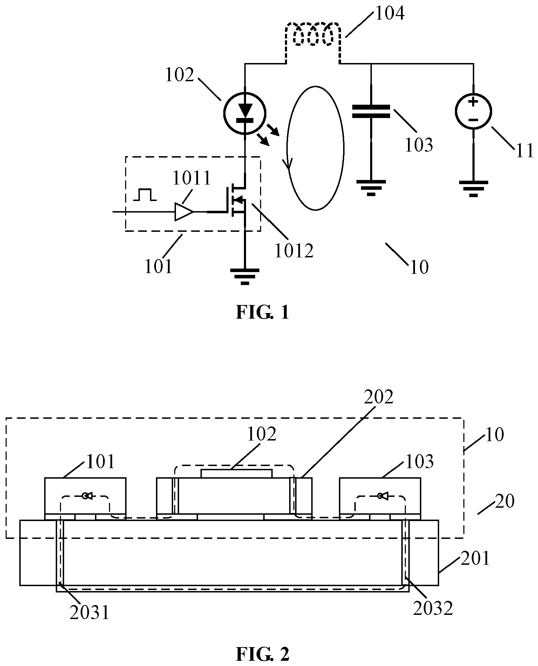

Before describing specific embodiments, a principle of a laser emitting circuit included in a laser emitting apparatus provided by various embodiments of the present application is described first. FIG. 1 illustrates a circuit schematic diagram of a laser emitting circuit in a laser emitting apparatus provided by various embodiments of the present application. FIG. 1 illustrates a laser emitting apparatus 10. The laser emitting circuit includes a drive chip 101, a laser emitting chip 102, and a capacitor 103 as an example useful for the understanding of the present invention.

The drive chip 101 includes a Schmidt trigger 1011 and a Metal Oxide Semiconductor (MOS) transistor 1012. An input end of the Schmidt trigger 1011 is connected with a pulse signal, and an output end of the Schmidt trigger 1011 is connected to a gate electrode of the MOS transistor 1012.

A drain electrode of the MOS transistor 1012 is connected to an output end of the laser emitting chip 102, and a source electrode of the MOS transistor 1012 is grounded.

One end of the capacitor 103 is connected to an input end of the laser emitting chip 102 and a positive electrode of an external power supply 11, and the other end of the capacitor 103 is grounded.

In FIG. 1, the pulse signal is input into the input end of the Schmidt trigger 1011. The Schmidt trigger 1011 performs waveform shaping on the pulse signal and then outputs the pulse signal to the gate electrode of the MOS transistor 1012, so as to control the MOS transistor 1012 to be turned on or turned off. When the MOS transistor 1012 is turned off, the external power supply 11 charges the capacitor 103. When the MOS transistor is turned on, the capacitor 103 discharges to the laser emitting chip 102, and the laser emitting chip 102 emits laser under the action of an instantaneous current.

Exemplarily, the Schmidt trigger 1011 performs waveform shaping on the input pulse signal. When the pulse signal subjected to the waveform shaping is input into the gate electrode of the MOS transistor 1012, if the pulse signal is a high level, the MOS transistor 1012 is turned on, at this moment, the capacitor 103 discharges to the laser emitting chip 102. Specifically, the capacitor 103 generates an instantaneous current that flows to the laser emitting chip 102, so as to enable the laser emitting chip 102 to emit laser under the action of the instantaneous current.

It is to be noted that because the pulse signal is a high level only for a period of time in a cycle, the current generated by the capacitor 103 is only an instantaneous current maintained for a period of time. The inductance has the property of hindering the change of a high-frequency current, when the instantaneous current flows to the laser emitting chip 102, the change of the current in the circuit becomes slow because the parasitic inductance 104 inside the laser emitting circuit is relatively large, that is, the change rate of the current input to the laser emitting chip is reduced, the rise time of the current input into the laser emitting chip becomes longer, and a narrow pulse signal input into the gate electrode of the MOS transistor has changed from a high level into a low level even when the current input to the laser emitting chip 102 does not rise to a maximum value, so that the MOS transistor 1012 is turned off to turn off the laser emission, a desired peak current cannot be reached, while the peak current is in positive correlation with peak optical power, thus, the peak power of the laser emitting chip 102 emitting laser is reduced, and the anti-interference capability is reduced easily due to the influence of ambient light. It is to be noted that the parasitic inductance 104 as shown in FIG. 1 is generated by performing equivalence on the inductance property of the whole circuit since the circuit element itself has an inductance property. The parasitic inductance 104 is not an actual element, but a schematic diagram only for explaining a circuit principle. It is to be noted that the parasitic inductance 104 is mainly generated by the inductance property exhibited by connecting lines among various circuit elements and a Ground terminal (GND) in a circuit. Of course, the circuit elements also exhibit the inductance property to a certain degree, which is not limited in the present application. In the present application, the parasitic inductance 104 may include the inductance generated by all or part of the circuit elements exhibiting the inductance property.

In order to further describe the characteristics of the parasitic inductance, the relationship between a current and a voltage of the parasitic inductance is described. The voltage V of the parasitic inductance is calculated according to Formula 1:

$$V = L \frac{dI}{dt} \text{, Formula 1:}$$

Where, V represents the voltage at two ends of the parasitic inductance 104, L represents an inductance value of the parasitic inductance 104, and $\frac{dI}{dt}$ represents the change rate of an instantaneous current. In combination with the circuit structure as shown in FIG. 1, the instantaneous current flows from the capacitor 103 through the parasitic inductance 104, then flows through the laser emitting chip 102, and finally flows through the MOS transistor 1012 to a GND terminal. In this circuit structure, the voltage V at the two ends of the parasitic inductance 104 is regarded as basically unchanged when the instantaneous current flows, so that the change rate

$$\frac{dI}{dt}$$

of the instantaneous current can be improved by reducing the inductance value L of the parasitic inductance.

Example useful for the understanding of the present invention.

Based on the circuit principle analysis of the abovementioned laser emitting circuit, the example useful for the understanding of the present invention. of the present application provides a structural diagram of a laser emitting apparatus. As shown in FIG. 2, which is a sectional view of the laser emitting apparatus, the laser emitting apparatus 20 includes a laser emitting circuit 10, a Printed Circuit Board (PCB) 201, and a substrate 202. The laser emitting circuit 10 is fixed to an upper surface of the PCB 201.

The laser emitting circuit 10 includes a laser emitting chip 102, a drive chip 101, and a capacitor 103. The laser emitting chip 102 is fixed to the substrate 202. The substrate 202, the drive chip 101, and the capacitor 103 are all fixed to the upper surface of the PCB 201. The laser emitting chip 102, the drive chip 101, and the capacitor 103 may respectively be equivalent to the circuit elements with the same reference sign in FIG. 1.

It is to be noted that the substrate 202 may be made of an insulating layer such as ceramic. Of course, it is only illustrative here and does not mean that the present application is limited thereto. The substrate 202 is used to package the laser emitting chip 102. The laser emitting chip 102 is fixed to the upper surface of the substrate 202.

A GND terminal is arranged in the PCB 201. As shown in FIG. 2, two ground holes are formed in the PCB 201, which are respectively a first ground hole 2031 and a second ground hole 2032. The first ground hole 2031 is formed below the drive chip 101, and the drive chip 101 is connected to the GND terminal through the first ground hole 2031. In a similar way, the second ground hole 2032 is arranged below the capacitor 103, and the capacitor 103 is connected to the GND terminal through the second ground hole 2032. The drive chip 101 and the capacitor 103 are respectively connected to the laser emitting chip 102. Optionally, the drive chip 101 may be connected between an output end of the laser emitting chip 102 and the GND terminal, and the capacitor 103 may be connected between an input end of the laser emitting chip 102 and the GND terminal. When the laser emitting chip 102 operates, a current flows in from the input end of the laser emitting chip 102 and flows out from the output end of the laser emitting chip 102. In an optional application scenario, the laser emitting chip 102 may include at least one laser diode. The at least one laser diode may be connected in parallel or in series. The anode of the laser diode is the input end of the laser emitting chip 102, the cathode of the laser diode is the output end of the laser emitting chip 102, and the current flows from the anode of the laser diode to the cathode of the laser diode.

In the laser emitting apparatus 20, the parasitic inductance of the whole circuit includes local self-inductance of a power supply, local self-inductance of the ground, and local mutual inductance of the power supply and the ground, as shown in Formula 2:

$$L_{loop} = L_a + L_b - 2L_{ab}, \text{ Formula 2;}$$

Where, $L_{loop}$ represents the parasitic inductance of the whole circuit, $L_{loop}$ may be equivalent to the inductance quantity of the inductance 104 in FIG. 1, $L_a$ represents local self-inductance of the power supply, $L_b$ represents local self-inductance of the ground, and $L_{ab}$ represents local mutual inductance of the power supply and the ground. It is to be noted that the local self-inductance of the power supply is formed by the inductance property exhibited by the connecting lines among various circuit elements. The local self-inductance of the ground is formed by the inductance property exhibited by the GND terminals of various circuit elements. The local mutual inductance of the power supply and the ground is generated by mutual influence of the current in a left direction in the connecting line on the PCB 201 and the current in a right direction in the GND terminal of the PCB 201. In the present application, a mutual inductance phenomenon can be understood as a phenomenon that an induced electromotive force is generated in another adjacent conducting wire when the current in one conducting wire changes.

Therefore, the parasitic inductance of the whole circuit can be reduced by reducing the local self-inductance of the power supply, reducing the local self-inductance of the ground, or increasing the local mutual inductance of the power supply and the ground. Specifically, the inductance of the connecting line can be reduced by reducing the length of the connecting line or increasing the width of the connecting line. That is to say, the local self-inductance of the power supply can be reduced by reducing the length of the connecting line, or increasing the width of the connecting line; and the local self-inductance of the ground can be reduced by reducing the length of the GND terminal, or increasing the width of the GND terminal. In addition, the mutual inductance between two conducting wires can be increased by reducing the distance between two conducting wires, and the mutual inductance between the two conducting wires can be reduced by increasing the distance between the two conducting wires.

Embodiment :

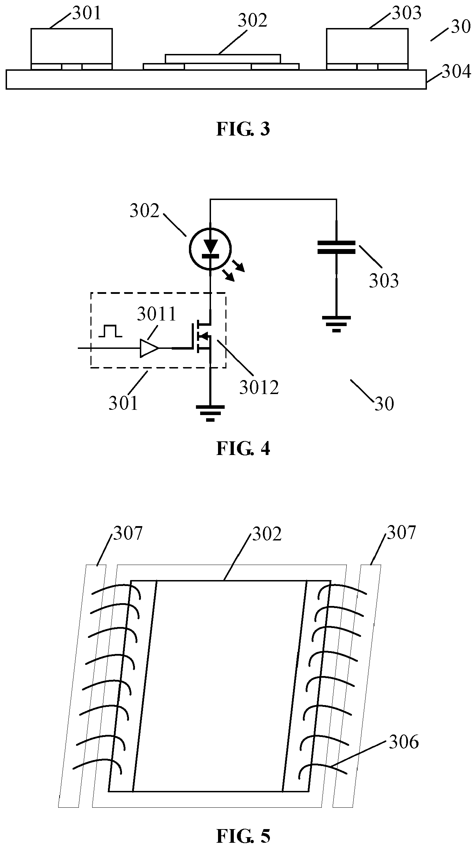

In combination with the example useful for the understanding of the present invention. above, Embodiment of the present application provides a laser emitting apparatus. As shown in FIG. 3, which illustrates a sectional view of a laser emitting apparatus provided by Embodiment 3 of the present application, it is to be noted that the laser emitting apparatus as shown in FIG. 3 is based on the principle of the laser emitting circuit as shown in FIG. 1, is the same as the principle of the laser emitting apparatus as shown in FIG. 2, and is a further improvement of the laser emitting apparatus as shown in FIG. 2. The laser emitting apparatus 30 includes: a drive assembly 301, a laser emitter 302, an energy storage module 303, and a circuit board 304.

The laser emitter 302 is a bare-die laser emitter. An input end of the laser emitter 302 is electrically connected to the energy storage module 303, and an output end of the laser emitter 302 is electrically connected to the drive assembly. The energy storage module 303 is electrically connected to an external power supply. The energy storage module 303 and the external power supply are used to generate an electrical signal required for driving the laser emitter 302. The drive assembly 301 is used to output a driving signal to control the energy storage module 303 and the external power supply to output the electrical signal to the laser emitter 302, so as to enable the laser emitter 302 to emit laser. The drive assembly 301, the laser emitter 302, and the energy storage module 303 are fixed on the circuit board 304, and a ground layer is arranged in the circuit board 304.

The drive assembly 301 may include a drive chip 101 in the circuit as shown in FIG. 1. The drive assembly 301 is used to output the driving signal to control a circuit where the laser emitter 302 is located to be turned on or turned off, so as to control the energy storage module 303 and the external power supply to output the electrical signal to the laser emitter 302, thereby enabling the laser emitter 302 to emit laser. The circuit where the laser emitter 302 is located is the circuit on the circuit board 304, that is to say, the circuit in the laser emitting apparatus 30. A specific principle may refer to the circuit principle shown in FIG. 1, which will not be elaborated here.

The laser emitter 302 may include the laser emitting chip 102 in the circuit as shown in FIG. 1. An internal structure of the laser emitter 302 may refer to the internal structure of the laser emitting chip 102 described in an example useful for the understanding of the invention corresponding to FIG. 2.

The energy storage module 303 is used to store charge, and the energy storage module 303 may include at least one capacitor 103 in the circuit as shown in FIG. 1. Of course, the above is only illustrative of the functions of the drive assembly 301, the laser emitter 302, and the energy storage module 303, and does not mean that the present application is limited thereto.

Since the laser emitter 302 is a bare-die laser emitter, it can also be said that the laser emitter 302 is not packaged, and there is no substrate for packaging between the laser emitter 302 and the circuit board 304, so that the distance between the laser emitter 302 and a ground layer of the circuit board 304 is reduced, local mutual inductance is increased, the distance between the laser emitter 302 and other circuit elements in the laser emitting apparatus 30 is also reduced, local self-inductance is reduced, and parasitic inductance generated by the circuit in the laser emitting apparatus is reduced on the whole, so that the change of an instantaneous current of the electric signals output to the laser emitter 302 by the energy storage module 303 and the external power supply under the control of the driving signal is accelerated, the anti-interference capability of laser emission is improved, and the effect of laser emission is improved.

The distance between a lower surface of the laser emitter 302 and an upper surface of the circuit board 304 is less than or equal to 30 $\mu$m. The distance between the lower surface of the laser emitter 302 and the upper surface of the circuit board 304 is less than the distance between the lower surface of the laser emitter 302 and the ground layer of the circuit board 304. Of course, the distance between the lower surface of the laser emitter 302 and the upper surface of the circuit board 304 is less than or equal to other values, such as 20 $\mu$m. Firstly, the distance between the laser emitter 302 and the circuit board 304 is less than or equal to 30 $\mu$m, so that the distance between the laser emitter 302 and the ground layer of the circuit board 304 is reduced, which increases the local mutual inductance of the laser emitter 302 and the ground, and reduces the parasitic inductance of the whole circuit. Secondly, the distance between the laser emitter 302 and the circuit board 304 is reduced, so that the distance between the laser emitter 302 and other elements on the circuit board 304 is reduced, which reduces the length of the connecting lines between the laser emitter 302 and other elements, and reduces the parasitic inductance of the whole circuit of the laser emitting apparatus 30. The parasitic inductance of the whole circuit is reduced for both reasons, so that the change rate of instantaneous current is improved, the peak power of laser emission is improved, and the anti-interference capacity of laser emission is improved.

It is to be noted that the distance between the laser emitter 302 and the circuit board 304 may be defined as the distance between the lower surface of the laser emitter 302 and the upper surface of the circuit board 304. When the lower surface of the laser emitter 302 is parallel to the upper surface of the circuit board 304, the distance between the laser emitter 302 and the circuit board 304 is the distance between two planes. When the lower surface of the laser emitter 302 is not parallel to the upper surface of the circuit board 304, the distance between the laser emitter 302 and the circuit board 304 is the distance between any point of the lower surface of the laser emitter 302 and a closest point of the upper surface of the circuit board 304. Of course, here is only illustrative, and does not mean that the present application is limited thereto.

A circuit structure of the laser emitting device 30 is described as follows.

Optionally, a first end of the energy storage module 303 is electrically connected to an input end of the laser emitter 302, and a second end of the energy storage module 303 is grounded.

An output end of the laser emitter 302 is electrically connected to a first input end of the drive assembly 301.

A second input end of the drive assembly 301 is connected with a pulse signal, and an output end of the drive assembly 301 is grounded.

As shown in FIG. 4, which is a schematic structural diagram of a circuit of a laser emitting apparatus provided by various embodiments of the present application, the drive assembly 301 in the present embodiment may be a drive chip 101 in the example useful for the understanding of the invention, the laser emitter 302 may be a laser emitting chip 102 in the example useful for the understanding of the invention, the energy storage module 303 may include at least one capacitor, for example, one capacitor or a combination of a plurality of capacitors, and the capacitor may be the same as the capacitor 103 in the example useful for the understanding of the invention. Of course, here is only illustrative, and does not mean that the present application is limited thereto. The drive assembly 301 may also be other structures used to generate a driving signal. The laser emitter 302 may also be a device of other structures for emitting laser under the control of the driving signal. For example, the laser emitter 302 may include a laser diode array, which includes at least one laser diode. The energy storage module 303 may also be other elements used to store energy.

Optionally, as shown in FIG. 4, the drive assembly 301 includes a waveform shaping circuit 3011 and a switching unit 3012.

An input end of the waveform shaping circuit 3011 is a second input end of the drive assembly 301. An input end of the waveform shaping circuit 3011 is connected with a pulse signal, and an output end of the waveform shaping circuit 3011 is connected to a control end of the switching unit 3012.

An input end of the switching unit 3012 is a first input end of the drive assembly 301, and the input end of the switching unit 3012 is electrically connected to the output end of the laser emitter 302. An output end of the switching unit 3012 is an output end of the drive assembly 301, and the output end of the switching unit 3012 is grounded.

Optionally, as shown in FIG. 4, in one embodiment of the present application, the switching unit 3012 is a field effect transistor 3112.

A drain electrode of the field effect transistor 3112 is the input end of the switching unit 3012, a gate electrode of the field effect transistor 3112 is a control end of the switching unit 3012, and a source electrode of the field effect transistor 3112 is the output end of the switching unit 3012. The drain electrode of the field effect transistor 3112 is electrically connected to the output end of the laser emitter 302. The gate electrode of the field effect transistor 3112 is electrically connected to the output end of the waveform shaping circuit 3011. The source electrode of the field effect transistor 3112 is grounded. Exemplarily, the field effect transistor 3112 may be an MOS transistor.

Exemplarily, a fixing mode of the laser emitter is described. As shown in FIG. 5, which is a schematic diagram of a fixing effect of the laser emitter provided by various embodiments of the present application. The laser emitter 302 is fixed to an upper surface of the circuit board 304 through at least one anode connecting line 306, and a cathode of the laser emitter 302 is arranged on a lower surface of the laser emitter 302.

The laser emitter 302 is fixed to the upper surface of the circuit board 304 through the anode connecting line 306 without adding other fixing components. The anode fixing line 306 not only achieves an effect of fixing the laser emitter 302, but also can connect an anode of the laser emitter 302, so that a circuit structure is simplified.

It is to be noted that the anode of the laser emitter 302 is a current input end, and the cathode of the laser emitter 302 is a current output end. Optionally, the laser emitter 302 may include at least two laser diodes connected that are connected in parallel, or may also include at least two laser diodes that are connected in series. The anode of the laser emitter 302 may also be the anode of the laser diode (the current input end), and the cathode of the laser emitter 302 may also be the cathode of the laser diode (the current output end).

Optionally, in one embodiment of the present application, a nickel-palladium-gold layer 307 is arranged between the laser emitter 302 and the circuit board 304, and at least one anode connecting line 306 is bound to the nickel-palladium-gold layer 307. The anode connecting line 306 can be connected better due to good electrical conductivity of the nickel-palladium-gold layer 307.

The cathode of the laser emitter is fixed to the upper surface of the circuit board through silver paste. The cathode of the laser emitter 302 is arranged on the lower surface of the laser emitter 302, silver paste is arranged between the lower surface of the laser emitter 302 and the upper surface of the circuit board 304, and the drive assembly 301 is connected to the cathode of the laser emitter 302 through the silver paste.

Optionally, a specific implementation mode is listed here for description. The laser emitter 302 may include at least two laser diodes that are connected in parallel. The anode of each laser diode is bound to the nickel-palladium-gold layer 307 through the anode connecting line 306. Of course, electrical connection between the anode of each laser diode and the nickel-palladium-gold layer 307 through the anode connecting line 306 is also realized, and the energy storage module 303 may be electrically connected to the nickel-palladium-gold layer 307.

In combination with the laser emitter corresponding to FIG. 3 above, the parasitic inductance of the circuit can also be reduced by reducing the distance between the laser emitter and the GND terminal. Optionally, in an implementation mode, the distance between the lower surface of the laser emitter 302 and the ground layer of the circuit board 304 is less than or equal to 0.1 mm. Further, the distance between the lower surface of the laser emitter 302 and the ground layer of the circuit board 304 may be less than 100 $\mu$m. For example, the distance between the lower surface of the laser emitter 302 and the ground layer of the circuit board 304 may be less than or equal to 90 $\mu$m, may also be less than or equal to 50 $\mu$m, or may also be less than or equal to 20 $\mu$m. It is to be noted that the distance between the lower surface of the laser emitter 302 and the ground layer of the circuit board 304 may be defined from a plurality of perspectives. The distance between the lower surface of the laser emitter 302 and the ground layer of the circuit board 304 may be the distance between the lower surface of the laser emitter 302 and the upper surface of the ground layer of the circuit board 304, or may also be the distance between the lower surface of the laser emitter 302 and the lower surface of the ground layer of the circuit board 304. Exemplarily, taking the lower surface of the laser emitter 302 and the lower surface of the ground layer of the circuit board 304 as an example for describing, if the lower surface of the laser emitter 302 is parallel to the lower surface of the ground layer of the circuit board 304, then the distance between the lower surface of the laser emitter 302 and the lower surface of the ground layer of the circuit board 304 is the distance between two planes. For another example, if the lower surface of the laser emitter 302 is not parallel to the lower surface of the ground layer of the circuit board 304, then the distance between the lower surface of the laser emitter 302 and the lower surface of the ground layer of the circuit board 304 may be the distance between any point of the lower surface of the laser emitter 302 and a closest point on the lower surface of the ground layer of the circuit board 304. Of course, here is only illustrative, and does not mean that the present application is limited thereto.

The distance between the lower surface of the laser emitter 302 and the ground layer of the circuit board 304 is relatively small, that is, the distance between connecting lines among various circuit elements in the circuit and the ground layer of the circuit board 304 is reduced, in combination with the explanation in the embodiment of FIG. 2, the distance between two conducting wires is reduced, and the mutual inductance of the two conducting wires is increased, that is, the local mutual inductance of the power supply and the ground is increased, so that the parasitic inductance of the whole circuit is reduced. When the pulse signal controls the laser emitting apparatus 30 to generate an instantaneous current, the change rate of the instantaneous current is increased, and the peak power of the laser emission is improved, so that the anti-interference capability of laser emission is improved.

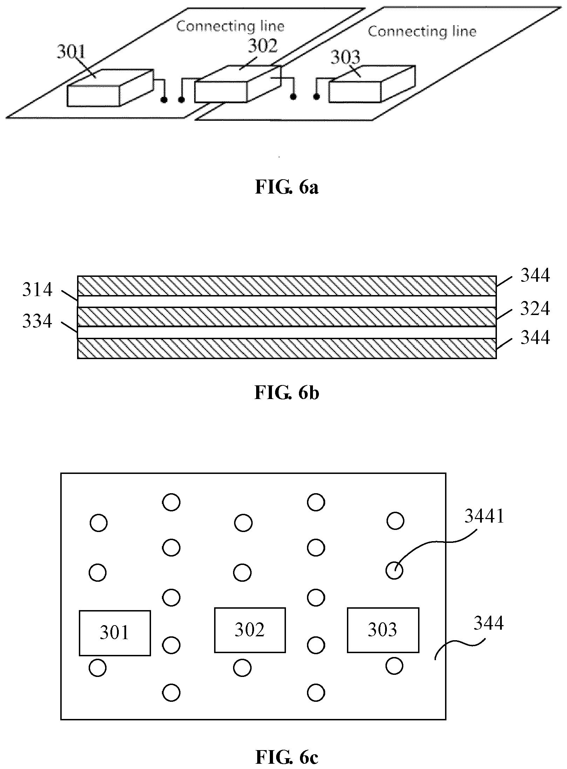

It is to be noted that in order to reduce the resistance of the connecting line, the width of the connecting line can be increased. For example, the connecting line may be a copper sheet, and connecting lines spread all over a wiring layer of the whole circuit board, while the ground arranged in the circuit board may also be a ground layer that spreads copper sheets all over the whole circuit board. Specifically, as shown in FIG. 6a, which illustrates a schematic shape diagram of a connecting line provided by various embodiments of the present application, two connecting lines, that is, two copper sheets are arranged in FIG. 6a. One copper sheet is connected to the drive assembly 301 and the laser emitter 302, and the other copper sheet is connected to the laser emitter 302 and the energy storage module 303. Since the width of the connecting line is relatively large, the resistance is reduced, meanwhile, the inductance of the connecting line itself can also be reduced, and the parasitic inductance of the whole circuit is also reduced (the inductance may be reduced since the wiring is short and thick). Optionally, in combination with FIG. 6b, which illustrates a sectional view of a circuit board provided by various embodiments of the present application, in one embodiment of the present application, the circuit board 304 includes a wiring layer 314, an intermediate dielectric layer 324, and a ground layer 334. The intermediate dielectric layer 324 is located between the wiring layer 314 and the ground layer 334. The thickness of the intermediate dielectric layer 324 is between 12.5 $\mu$m and 50 $\mu$m. It is to be noted that the wiring layer 314 is used to connect various circuit elements in the circuit. The ground layer 334 is a GND terminal of the power supply, both the wiring layer 314 and the ground layer 334 may be copper sheets, and the intermediate dielectric layer 324 may be made of a dielectric material, such as polyimide resin. Of course, the circuit board 304 may further include other layers. For example, an insulating dielectric layer 344 may also be arranged above the wiring layer 314 of the circuit board, and an insulating dielectric layer 344 may also be arranged below the ground layer 334 of the circuit board. In one example, the thickness of the wiring layer 314 and the ground layer 334 may be 12 $\mu$m. The insulating dielectric layer 344 may also be made of a dielectric material, such as polyimide resin, or may be of a combined structure of a resin material layer and a thermosetting adhesive layer, and the thickness of the insulating dielectric layer 344 may be between 20 and 30 $\mu$m.

In combination with FIG. 6a and FIG. 6b, FIG. 6c illustrates a vertical view of the circuit board provided by various embodiment of the present application. In FIG. 6c, an insulating dielectric layer 344 is arranged above the wiring layer 314 of the circuit board 304. Connecting holes 3441 are formed in the insulating dielectric layer 344. Various circuit elements (the drive assembly 301, the laser emitter 302, and the energy storage module 303) are connected to the wiring layer 314 through the connecting holes 3441, and interconnection of various circuit elements is realized through the wiring layer 314. Of course, here is only illustrative, and does not mean that the present application is limited thereto.

Optionally, in an implementation mode, the thickness of the intermediate dielectric layer 324 of the circuit board 304 is less than or equal to 25 $\mu$m, or in another implementation mode, the thickness of the intermediate dielectric layer 324 of the circuit board 304 may be 12.5 $\mu$m, and in yet another implementation mode, the thickness of the intermediate dielectric layer 324 of the circuit board 304 may also be 20 $\mu$m, which is only illustrative here, and does not mean that the present application is limited thereto.

The wiring layer of the circuit board may be arranged to be consistent with the size and shape of the ground layer to further increase the effect of mutual inductance, so as to reduce the parasitic inductance of the whole circuit, thereby improving the peak power of laser emission and improving the anti-interference capability of the laser emission.

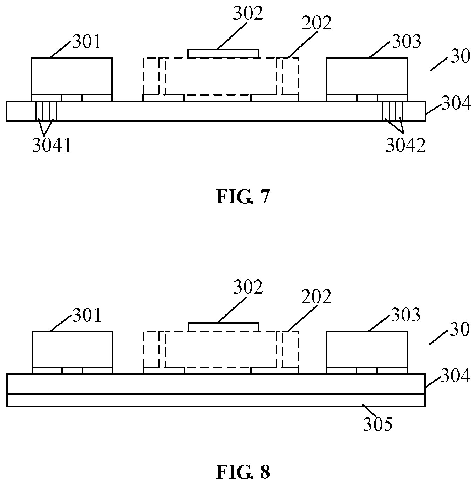

Optionally, in one embodiment of the present application, as shown in FIG. 7, which is a sectional view of a second laser emitter provided by Embodiment -2- of the present application, the laser emitting apparatus 30 as shown in FIG. 7 is a further improvement of the laser emitting apparatus 30 as shown in FIG. 3 as long as the substrate 202 is not present. As shown in FIG. 7, the laser emitting apparatus 30 includes: a drive assembly 301, a laser emitter 302, an energy storage module 303, and a circuit board 304. The drive assembly 301 is electrically connected to the laser emitter 302. The laser emitter 302 is electrically connected to the energy storage module 303. The energy storage module 303 is electrically connected to an external power supply (or a power supply module). The drive assembly 301, the laser emitter 302, and the energy storage module 303 are fixed above the circuit board 304. A ground layer is arranged in the circuit board 304. The distance between the lower surface of the laser emitter and the ground layer of the circuit board is less than or equal to 0.1 mm.

A first ground hole 3041 and a second ground hole 3042 are formed in the circuit board 304.

The first ground hole 3041 is formed below the drive assembly 301, and the drive assembly 301 is grounded through the first ground hole 3041.

The second ground hole 3042 is formed below the energy storage module 303, and the energy storage module 303 is grounded through the second ground hole 3042.

It is to be noted that the ground holes described in the present embodiment have the same function as the first ground hole 2031 and the second ground hole 2032 described in Embodiment, which are all used for a connecting line connected to the GND terminal to pass through. In the present embodiment, the number of the first ground hole 3041 may be at least one, and the number of the second ground hole 3042 may also be at least one. A ground wire used to connect the GND terminal is arranged in the first ground hole 3041 and the second ground hole 3042. The greater the number of the first ground hole 3041 and the second ground hole 3042, the greater the number of the ground wires, which is equivalent to increasing the cross section of the ground wire, thereby further reducing the resistance and the inductance of the ground wire, improving the change rate of an instantaneous current, improving the peak power of laser emission, and improving the anti-interference capacity of laser emission. FIG. 7 exemplarily illustrates two first ground holes 3041 and two second ground holes 3042, which is only illustrative, and does not mean that the present application is limited thereto.

The connecting line connected to the GND terminal needs to penetrate through the ground hole and penetrates through the circuit board 304, while the thickness of the circuit board 304 is less than or equal to a preset thickness, which reduces the length of the connecting line to a certain extent, further reduces the parasitic inductance of the whole circuit, enhances the change rate of an instantaneous current, and improves the anti-interference capacity of laser emission.

Optionally, in one embodiment of the present application, the preset thickness is 100 $\mu$m. For example, the circuit board 304 may be a Flexible Printed Circuit (FPC).

Exemplarily, as shown in FIG. 8, which illustrates a sectional view of a third laser emitting apparatus provided by Embodiment of the present application, the laser emitting apparatus 30 as shown in FIG. 8 is a further improvement of the laser emitting apparatus 30 as shown in FIG. 3 as long as the substrate 202 is not present. As shown in FIG. 8, the laser emitting apparatus 30 includes: a drive assembly 301, a laser emitter 302, an energy storage module 303, and a circuit board 304. The drive assembly 301 is electrically connected to the laser emitter 302. The laser emitter 302 is electrically connected to the energy storage module 303. The energy storage module 303 is electrically connected to an external power supply (or a power supply module). The drive assembly 301, the laser emitter 302, and the energy storage module 303 are fixed above the circuit board 304. A ground layer is arranged in the circuit board 304. The distance between the lower surface of the laser emitter 302 and the ground layer of the circuit board 304 is less than or equal to 0.1 mm. The laser emitting apparatus 30 further includes a reinforcing plate 305, and the reinforcing plate 305 is fixed to the lower surface of the circuit board 304. Since the distance between the lower surface of the laser emitter 302 and the ground layer of the circuit board 304 is relatively small, the reinforcing plate 305 can improve the structural strength. Exemplarily, the material of the reinforcing plate 305 may be steel. If the PCB is directly used, the structural strength of the laser emitter may be ensured. However, the PCB is too thick, so that the distance between the GND terminal and the circuit element (the drive assembly 301, the laser emitter 302, and the energy storage module 303) is relatively large. Compared with the PCB, the distance between the GND terminal and the circuit element can be reduced by using the FPC, so that the mutual inductance between the power supply and the ground is increased, and the parasitic inductance of the whole circuit is reduced. In addition, the structural strength can also be enhanced by the reinforcing plate 305. Compared with the PCB, not only the structural strength is ensured, but also the parasitic inductance is reduced, the change rate of an instantaneous current is improved, the peak power of laser emission is improved, and the anti-interference capacity of laser emission is improved.

The laser emitting chip and the laser emitter described in the embodiments of the present application may be a Vertical-Cavity Surface-Emitting Laser (VCSEL).

According to the laser emitting apparatus provided by the embodiments of the present application, since the laser emitter is a bare-die laser emitter, the distance between the laser emitter and the ground layer of the circuit board is reduced, local mutual inductance is increased, the distance between the laser emitter and other circuit elements in the laser emitting apparatus is also reduced, local self-inductance is reduced, and parasitic inductance generated by the circuit in the laser emitting apparatus is reduced on the whole, so that the change of an instantaneous current generated when the driving signal controls the laser emitting apparatus is accelerated, the anti-interference capability of laser emission is improved, and the effect of laser emission is improved.

It is also to be noted that terms "include", "contain" or any other variations thereof are intended to cover a non-exclusive inclusion, so that a process, method, item, or device including a series of elements includes not only those elements, but also other elements not explicitly listed, or elements that are inherent to such process, method, commodity, or device. In the absence of more restrictions, elements defined by the phrase "include a/an..." do not exclude the existence of additional identical elements in the process, method, commodity, or device that includes the elements.

Various embodiments in this specification are all described in a progressive manner. For same or similar parts among various embodiments, mutual reference may be made. Each embodiment focuses what is different from other embodiments. Particularly, for a system embodiment, since it is basically similar to a method embodiment, the description is relatively simple, and relevant parts can be referred to the description of the method embodiment.

The above descriptions are only embodiments of the present application, and are not intended to limit the present application. For those skilled in the art, the present application may have various changes and variations as long as they fall under the scope claimed.

## Claims

1. A laser emitting apparatus (30), comprising: a drive assembly (301), a laser emitter (302), an energy storage module (303), and a circuit board (304), wherein

   the laser emitter (302) is a bare-die laser emitter, an input end of the laser emitter (302) is electrically connected to the energy storage module (303), an output end of the laser emitter (302) is electrically connected to the drive assembly (301);
   the energy storage module (303) is electrically connected to an external power supply, the energy storage module (303) and the external power supply are configured to generate an electrical signal for driving the laser emitter (302);
   the drive assembly (301) is configured to output a driving signal to control the energy storage module (303) and the external power supply to output the electrical signal to the laser emitter (302), so as to cause the laser emitter to emit laser;
   the drive assembly (301), the laser emitter (302), and the energy storage module (303) are fixed on the circuit board (304), and a ground layer (334) is arranged in the circuit board (304);
   wherein the input end of the laser emitter (302) is an anode of the laser emitter (302), and the output end of the laser emitter (302) is a cathode of the laser emitter (302); the anode of the laser emitter (302) is fixed to an upper surface of the circuit board (304) through at least one anode connecting line (306), and the cathode of the laser emitter (302) is arranged on a lower surface of the laser emitter (302), the laser emitter (302) is not packaged, and there is no substrate for packaging between the laser emitter (302) and the circuit board (304), silver paste is arranged between the lower surface of the laser emitter (302) and the upper surface of the circuit board (304) and the cathode of the laser emitter (302) is fixed to the upper surface of the circuit board (304) through the silver paste, and a distance between the lower surface of the laser emitter (302) and the upper surface of the circuit board (304) is less than or equal to 30 $\mu$m.

2. The laser emitting apparatus according to claim 1, wherein the laser emitter (302) comprises at least one laser diode, a cathode of the at least one laser diode is the cathode of the laser emitter (302), and an anode of the at least one laser diode is the anode of the laser emitter (302) and is connected to the at least one anode connecting line (306).

3. The laser emitting apparatus according to claim 2, wherein a nickel-palladium-gold layer (307) is arranged between the laser emitter (302) and the circuit board (304), and the at least one anode connecting line (306) is bound to the nickel-palladium-gold layer (307).

4. The laser emitting apparatus according to claim 1, wherein

   a first end of the energy storage module (303) is electrically connected to the input end of the laser emitter (302), and a second end of the energy storage module (303) is grounded;
   the output end of the laser emitter (302) is electrically connected to a first input end of the drive assembly (301);
   a second input end of the drive assembly (301) receives a pulse signal; and an output end of the drive assembly (301) is grounded.

5. The laser emitting apparatus according to claim 4, wherein the drive assembly (301) comprises a waveform shaping circuit (3011) and a switching unit (3012);

   an input end of the waveform shaping circuit (3011) is the second input end of the drive assembly (301), an output end of the waveform shaping circuit (3011) is connected to a control end of the switching unit (3012);
   an input end of the switching unit (3012) is the first input end of the drive assembly (301), and an output end of the switching unit (3012) is the output end of the drive assembly (301).

6. The laser emitting apparatus according to claim 4, wherein the switching unit (3012) is a field effect transistor; and
   a drain electrode of the field effect transistor is the input end of the switching unit (3012), a gate electrode of the field effect transistor is the control end of the switching unit (3012), and a source electrode of the field effect transistor is the output end of the switching unit (3012).

7. The laser emitting apparatus according to claim 1, wherein a distance between the lower surface of the laser emitter (302) and the ground layer (334) of the circuit board (304) is less than or equal to 0.1 mm.

8. The laser emitting apparatus according to claim 1, wherein the circuit board (304) comprises a wiring layer (314), an intermediate dielectric layer (324), and the ground layer (334), the intermediate dielectric layer (324) is located between the wiring layer

(314) and the ground layer (334); and a thickness of the intermediate dielectric layer (324) is between 12.5 $\mu$m and 50 $\mu$m.

9. The laser emitting apparatus according to claim 1, wherein the circuit board (304) is provided with a first ground hole (3041) and a second ground hole (3042);

> the first ground hole (3041) is provided below the drive assembly (301), and the drive assembly (301) is grounded through the first ground hole (3041); and
> the second ground hole (3042) is provided below the energy storage module (303), and the energy storage module (303) is grounded through the second ground hole (3042).

10. The laser emitting apparatus according to any one of claims 1 to 8, further comprising a reinforcing plate (305), wherein the reinforcing plate (305) is fixed to the lower surface of the circuit board (304).

11. The laser emitting apparatus according to any one of claims 1 to 10, wherein the energy storage module (303) is a capacitor.


**Patentansprüche**

1. Laseremissionsvorrichtung (30), umfassend: eine Ansteuerungsbaugruppe (301), einen Laseremitter (302), ein Energiespeichermodul (303) und eine Leiterplatte (304), wobei

> der Laseremitter (302) ein Bare-Die-Laseremitter ist, ein Eingangsende des Laseremitters (302) elektrisch mit dem Energiespeichermodul (303) verbunden ist, ein Ausgangsende des Laseremitters (302) elektrisch mit der Ansteuerungsbaugruppe (301) verbunden ist;
> das Energiespeichermodul (303) elektrisch mit einer externen Stromversorgung verbunden ist, das Energiespeichermodul (303) und die externe Stromversorgung konfiguriert sind, um ein elektrisches Signal zur Ansteuerung des Laseremitters (302) zu erzeugen;
> die Ansteuerungsbaugruppe (301) konfiguriert ist, um ein Ansteuersignal auszugeben, um das Energiespeichermodul (303) und die externe Stromversorgung zu steuern, um das elektrische Signal an den Laseremitter (302) auszugeben, um den Laseremitter zu veranlassen, Laser zu emittieren;
> die Ansteuerungsbaugruppe (301), der Laseremitter (302) und das Energiespeichermodul (303) auf der Leiterplatte (304) befestigt sind, und eine Erdungsschicht (334) in der Leiterplatte (304) angeordnet ist;
wobei das Eingangsende des Laseremitters (302) eine Anode des Laseremitters (302) ist, und das Ausgangsende des Laseremitters (302) eine Kathode des Laseremitters (302) ist; die Anode des Laseremitters (302) an einer Oberseite der Leiterplatte (304) durch mindestens eine Anodenverbindungsleitung (306) befestigt ist, und die Kathode des Laseremitters (302) auf einer Unterseite des Laseremitters (302) angeordnet ist, der Laseremitter (302) nicht verpackt ist und kein Substrat für eine Verpackung zwischen dem Laseremitter (302) und der Leiterplatte (304) vorhanden ist, Silberpaste zwischen der Unterseite des Laseremitters (302) und der Oberseite der Leiterplatte (304) angeordnet ist und die Kathode des Laseremitters (302) durch die Silberpaste an der Oberseite der Leiterplatte (304) befestigt ist, und ein Abstand zwischen der Unterseite des Laseremitters (302) und der Oberseite der Leiterplatte (304) kleiner oder gleich 30 $\mu$m ist.

2. Laseremissionsvorrichtung nach Anspruch 1, wobei der Laseremitter (302) mindestens eine Laserdiode umfasst, eine Kathode der mindestens einen Laserdiode die Kathode des Laseremitters (302) ist, und eine Anode der mindestens einen Laserdiode die Anode des Laseremitters (302) ist und mit der mindestens einen Anodenverbindungsleitung (306) verbunden ist.

3. Laseremissionsvorrichtung nach Anspruch 2, wobei eine Nickel-Palladium-Gold-Schicht (307) zwischen dem Laseremitter (302) und der Leiterplatte (304) angeordnet ist und die mindestens eine Anodenverbindungsleitung (306) an die Nickel-Palladium-Gold-Schicht (307) gebunden ist.

4. Laseremissionsvorrichtung nach Anspruch 1, wobei

> ein erstes Ende des Energiespeichermoduls (303) ist elektrisch mit dem Eingangsende des Laseremitters (302) verbunden, und ein zweites Ende des Energiespeichermoduls (303) ist geerdet;
> das Ausgangsende des Laseremitters (302) ist elektrisch mit einem ersten Eingangsende der Ansteuerungsbaugruppe (301) verbunden;
> ein zweites Eingangsende der Ansteuerungsbaugruppe (301) ein Impulssignal empfängt; und ein Ausgangsende der Ansteuerungsbaugruppe (301) geerdet ist.

5. Laseremissionsvorrichtung nach Anspruch 4, wobei die Ansteuerungsbaugruppe (301) eine Wellenformungsschaltung (3011) und eine Schalteinheit (3012) umfasst;

ein Eingangsende der Wellenformungsschaltung (3011) das zweite Eingangsende der Ansteuerungsbaugruppe (301) ist, ein Ausgangsende der Wellenformungsschaltung (3011) mit einem Steuerende der Schalteinheit (3012) verbunden ist;

ein Eingangsende der Schalteinheit (3012) das erste Eingangsende der Ansteuerungsbaugruppe (301) ist, und ein Ausgangsende der Schalteinheit (3012) das Ausgangsende der Ansteuerungsbaugruppe (301) ist.

6. Laseremissionsvorrichtung nach Anspruch 4, wobei die Schalteinheit (3012) ein Feldeffekttransistor ist; und

eine Drain-Elektrode des Feldeffekttransistors das Eingangsende der Schalteinheit (3012) ist, eine Gate-Elektrode des Feldeffekttransistors das Steuerende der Schalteinheit (3012) ist, und eine Source-Elektrode des Feldeffekttransistors das Ausgangsende der Schalteinheit (3012) ist.

7. Laseremissionsvorrichtung nach Anspruch 1, wobei der Abstand zwischen der Unterseite des Laseremitters (302) und der Erdungsschicht (334) der Leiterplatte (304) weniger als oder gleich 0,1 mm beträgt.

8. Laseremissionsvorrichtung nach Anspruch 1, wobei die Leiterplatte (304) eine Verdrahtungsschicht (314), eine dielektrische Zwischenschicht (324) und die Erdungsschicht (334) umfasst, die dielektrische Zwischenschicht (324) zwischen der Verdrahtungsschicht (314) und der Erdungsschicht (334) angeordnet ist und die Dicke der dielektrischen Zwischenschicht (324) zwischen 12,5 $\mu$m und 50 $\mu$m liegt.

9. Laseremissionsvorrichtung nach Anspruch 1, wobei die Leiterplatte (304) mit einem ersten Erdungsloch (3041) und einem zweiten Erdungsloch (3042) versehen ist;

das erste Erdungsloch (3041) unterhalb der Ansteuerungsbaugruppe (301) vorgesehen ist und die Ansteuerungsbaugruppe (301) durch das erste Erdungsloch (3041) geerdet ist; und das zweite Erdungsloch (3042) unterhalb des Energiespeichermoduls (303) vorgesehen ist und das Energiespeichermodul (303) durch das zweite Erdungsloch (3042) geerdet ist.

10. Laseremissionsvorrichtung nach einem der Ansprüche 1 bis 8, ferner umfassend: eine Verstärkungsplatte (305), wobei die Verstärkungsplatte (305) an der Unterseite der Leiterplatte (304) befestigt ist.

11. Laseremissionsvorrichtung nach einem der Ansprüche 1 bis 10, wobei das Energiespeichermodul (303) ein Kondensator ist.

## Revendications

1. Dispositif d'émission laser (30), comprenant : un ensemble d'entraînement (301), un émetteur laser (302), un module de stockage d'énergie (303) et une carte de circuit imprimé (304), dans lequel,

l'émetteur laser (302) est un émetteur laser à puce nue, une extrémité d'entrée de l'émetteur laser (302) est connectée électriquement au module de stockage d'énergie (303), une extrémité de sortie de l'émetteur laser (302) est connectée électriquement à l'ensemble d'entraînement (301) ;
le module de stockage d'énergie (303) est connecté électriquement à une source d'alimentation extérieure, le module de stockage d'énergie (303) et la source d'alimentation extérieure sont configurés pour générer un signal électrique pour entraîner l'émetteur laser (302) ;
l'ensemble d'entraînement (301) est configuré pour émettre un signal d'entraînement afin de commander le module de stockage d'énergie (303) et la source d'alimentation extérieure pour envoyer le signal électrique à l'émetteur laser (302), de sorte que l'émetteur laser émette un laser ;
l'ensemble d'entraînement (301), l'émetteur laser (302) et le module de stockage d'énergie (303) sont fixés sur la carte de circuit imprimé (304) et une couche de terre (334) est disposée dans la carte de circuit imprimé (304) ;
dans lequel l'extrémité d'entrée de l'émetteur laser (302) est une anode de l'émetteur laser (302) et l'extrémité de sortie de l'émetteur laser (302) est une cathode de l'émetteur laser (302) ; l'anode de l'émetteur laser (302) est fixée à une surface supérieure de la carte de circuit imprimé (304) par l'intermédiaire d'au moins une ligne de connexion d'anode (306), et la cathode de l'émetteur laser (302) est disposée sur une surface inférieure de l'émetteur laser (302), l'émetteur laser (302) n'est pas emballé et aucun substrat pour l'emballage n'est prévu entre l'émetteur laser (302) et la carte de circuit imprimé (304), une pâte d'argent est disposée entre la surface inférieure de l'émetteur laser (302) et la surface supérieure de la carte de circuit imprimé (304), la cathode de l'émetteur laser (302) est fixée à la surface supérieure de la carte de circuit imprimé (304) par l'intermédiaire de la pâte d'argent, et une distance entre la surface inférieure de l'émetteur laser (302) et la surface supérieure de la carte de circuit imprimé (304) est inférieure ou égale à 30 $\mu$m.

**2.** Dispositif d'émission laser selon la revendication 1, dans lequel l'émetteur laser (302) comprend au moins une diode laser, une cathode de l'au moins une diode laser est la cathode de l'émetteur laser (302) et une anode de l'au moins une diode laser est l'anode de l'émetteur laser (302) et est connectée à l'au moins une ligne de connexion d'anode (306).

**3.** Dispositif d'émission laser selon la revendication 2, dans lequel une couche de nickel-palladium-or (307) est disposée entre l'émetteur laser (302) et la carte de circuit imprimé (304), et au moins une ligne de connexion d'anode (306) est reliée à la couche de nickel-palladium-or (307).

**4.** Dispositif d'émission laser selon la revendication 1, dans lequel,

une première extrémité du module de stockage d'énergie (303) est connectée électriquement à l'extrémité d'entrée de l'émetteur laser (302) et une deuxième extrémité du module de stockage d'énergie (303) est mise à la terre ; l'extrémité de sortie de l'émetteur laser (302) est connectée électriquement à une première extrémité d'entrée de l'ensemble d'entraînement (301) ; une deuxième extrémité d'entrée de l'ensemble d'entraînement (301) reçoit un signal d'impulsion ; et une extrémité de sortie de l'ensemble d'entraînement (301) est mise à la terre.

**5.** Dispositif d'émission laser selon la revendication 4, dans lequel l'ensemble d'entraînement (301) comprend un circuit de mise en forme de forme d'onde (3011) et une unité de commutation (3012) ;

une extrémité d'entrée du circuit de mise en forme de forme d'onde (3011) est la deuxième extrémité d'entrée de l'ensemble d'entraînement (301), une extrémité de sortie du circuit de mise en forme de forme d'onde (3011) est connectée à une extrémité de commande de l'unité de commutation (3012) ; une extrémité d'entrée de l'unité de commutation (3012) est la première extrémité d'entrée de l'ensemble d'entraînement (301), et une extrémité de sortie de l'unité de commutation (3012) est l'extrémité de sortie de l'ensemble d'entraînement (301).

**6.** Dispositif d'émission laser selon la revendication 4, dans lequel l'unité de commutation (3012) est un transistor à effet de champ ; et une électrode de drain du transistor à effet de champ est l'extrémité d'entrée de l'unité de commutation (3012), une électrode de grille du transistor à effet de champ est l'extrémité de commande de l'unité de commutation (3012) et une électrode de source du transistor à effet de champ est l'extrémité de sortie de l'unité de commutation (3012).

**7.** Dispositif d'émission laser selon la revendication 1, dans lequel une distance entre la surface inférieure de l'émetteur laser (302) et la couche de terre (334) de la carte de circuit imprimé (304) est inférieure ou égale à 0,1 mm.

**8.** Dispositif d'émission laser selon la revendication 1, dans lequel la carte de circuit imprimé (304) comprend une couche de câblage (314), une couche diélectrique intermédiaire (324) et la couche de terre (334), la couche diélectrique intermédiaire (324) est située entre la couche de câblage (314) et la couche de terre (334) ; et l'épaisseur de la couche diélectrique intermédiaire (324) est comprise entre 12,5 $\mu$m et 50 $\mu$m.

**9.** Dispositif d'émission laser selon la revendication 1, dans lequel la carte de circuit imprimé (304) est pourvue d'un premier trou de terre (3041) et d'un deuxième trou de terre (3042) ;

le premier trou de terre (3041) est prévu sous l'ensemble d'entraînement (301), et l'ensemble d'entraînement (301) est mis à la terre par l'intermédiaire du premier trou de terre (3041) ; et le deuxième trou de terre (3042) est prévu sous le module de stockage d'énergie (303), et le module de stockage d'énergie (303) est mis à la terre par l'intermédiaire du deuxième trou de terre (3042).

**10.** Dispositif d'émission laser selon l'une quelconque des revendications 1 à 8, comprenant en outre une plaque de renfort (305), dans lequel la plaque de renfort (305) est fixée à la surface inférieure de la carte de circuit imprimé (304).

**11.** Dispositif d'émission laser selon l'une quelconque des revendications 1 à 10, dans lequel le module de stockage d'énergie (303) est un condensateur.

**FIG. 1**

**FIG. 2**

**FIG. 3**

**FIG. 4**

**FIG. 5**

**FIG. 6a**

**FIG. 6b**

**FIG. 6c**

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190312407 A
- US 20040233946 A1